Europäisches Patentamt

European Patent Office

Office européen des brevets

(11) Publication number: **0 361 078**
**A2**

# EUROPEAN PATENT APPLICATION

(21) Application number: **89115513.7**

(22) Date of filing: **23.08.89**

(51) Int. Cl.5: **H01L 21/225** , **H01L 21/336** , **H01L 21/285**

The title of the invention has been amended (Guidelines for Examination in the EPO, A-III, 7.3).

(30) Priority: **28.09.88 JP 245569/88**

(43) Date of publication of application:
**04.04.90 Bulletin 90/14**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Nishida, Kenji**
**9-5-314, Kouyoudai 5 chome**
**Inagi-shi Tokyo, 206(JP)**

(74) Representative: **Seeger, Wolfgang, Dipl.-Phys.**
**Georg-Hager-Strasse 40**
**D-8000 München 70(DE)**

(54) **Method of producing a semiconductor device having shallow highly doped regions.**

(57) A method for fabricating a semiconductor device, such as a silicon MOS FET, having diffusion regions with a reduced depth and high dopant concentration, is disclosed. Beneath the surface of the relevant semiconductor substrate, an amorphous layer is formed corresponding to the diffusion regions in advance, following which a doped polysilicon layer is formed. Thereafter, the polysilicon layer is doped employing a dopant ion implantation such that the peak point of the dopant concentration distribution is located substantially near the interface between the silicon substrate and the polysilicon layer. Subsequently, the substrate is subject to a rapid thermal annealing for diffusing the dopant from the doped polysilicon layer, recrystallizing the amorphous layer portion, and activating the dopant contained in the recrystallized layer portion to be the diffusion regions. A silicide layer is used in the place of the polysilicon layer to have a high electrical conductance.

EP 0 361 078 A2

# METHOD FOR FABRICATING A SEMICONDUCTOR DEVICE HAVING AN IMPURITY REGION WITH REDUCED DEPTH AND HIGH IMPURITY CONCENTRATION IN A SEMICONDUCTOR SUBSTRATE

## BACKGROUND OF THE INVENTION

Field of the invention

The present invention relates to a method for forming a semiconductor device. such as a large scale integrated circuit (LSI), having a fine structure suitable for high density integration. Particularly, it relates to a method for forming a shallow and high concentration impurity region in the relevant semiconductor substrate of the device.

Description of the related arts

Recently, the miniaturization of a semiconductor device. such as an LSI, is proceeding on, usually based on the well known scaling theory which requires the reduction of the physical dimensions of the device by the scaling factor l.k accompanied with the increase in impurity material (dopant) concentration of the substrate. Consequently, in the art, there has been required the development of an improved fabricating method for forming a shallow diffusion layer with high dopant concentration in order to obtain low diffusion resistance and low contact resistance to the relevant contact terminal.

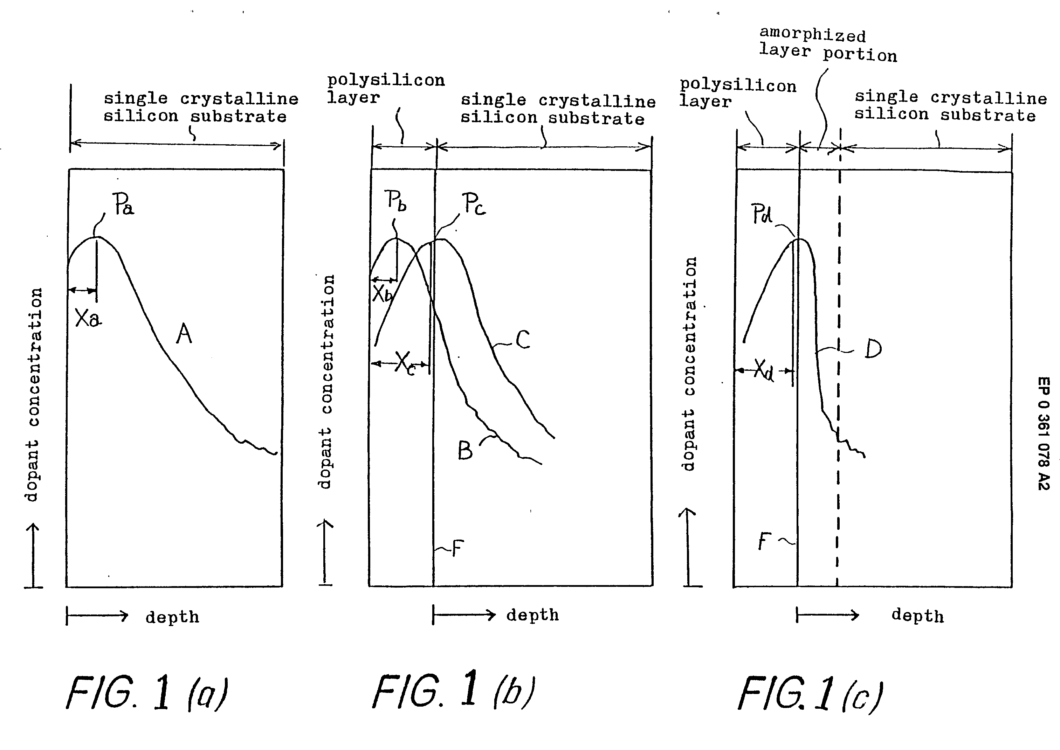

Before proceeding further, a brief survey of the ion implanting is described. An accelerated ion entering a solid layer will lose its energy through collision with the nuclei and electrons of the layer, and finally comes to rest. The total distance that the ion travels is referred to as range, and the projection of this distance on the direction of incidence of the ion is referred to as a projected range. The projected range varies depending on the accelerating energy and the collision state with the nuclei and electrons of the implanted layer material. In general, the projected range distribution is theoretically represented by a Gaussian distribution within a single crystalline structure, as shown in an article, titled "Ion implantation in semiconductors - part I" by J. F. Gibbons, published on Proceeding of the IEEE, Vol. 3, March 1968, for example. Experimentally, there is found a projected range distribution of implanted dopant, represented in a peaked concentration distribution curve. Apparently, the distribution of the projected range of implanted dopant is equivalent to that of the concentration of the dopant. Fig. 1 (a) is a schematic diagram A having a peak point Pa at a depth Xa, illustrating the distribution of the dopant concentration with respect to a single crystalline silicon substrate which is implanted with dopant normally incident on the surface of the substrate. The dopant concentration is taken on the coordinate and the depth from the surface is taken on the abscissa. The peak point Pa can be selectively varied by adjusting the associated accelerating energy.

Regarding the ion implantation, there is an effect known as "the channeling effect". Projected range distribution in a single crystalline body is quite different from those in an amorphous body under the same implantation condition. This is because of the possibility that incident ions can channel along open directions which appear when the incident ion beam is aligned with a low index crystallographic direction. The ions implanted into a single crystalline body are likely to be channeled, proceeding deeper in the body than in the amorphous body. In the diagram A of Fig. 1(a), therefore, the peak point Pa is followed by an elongated tail, which suggests that the direct ion implantation to a single crystalline silicon substrate is not suitable to form a shallow and high dopant concentration diffused region.

In a method of the prior art, a solid-to-solid thermal diffusion technology is utilized to form a shallow diffusion region in a semiconductor substrate. In the method. a dopant carrying layer is formed over the surface of the substrate corresponding to doped regions (impurity regions) of the relevant MOS FET. The layer, for example, is a polycrystalline silicon layer (hereinafter, referred to as a polysilicon layer) containing dopant therein. The dopant is implanted into the polysilicon layer by employing an ion implanting method. Thereafter, the substrate is subject to a rapid thermal annealing (RTA), resulting in thermal diffusion of dopant contained in the polysilicon layer into the substrate through the interface surface between the polysilicon layer and the substrate.

Fig. 1 (b) is a schematic diagram, illustrating the distribution of the dopant concentration with respect to the above-described structure composed of the polysilicon layer and the single crystalline silicon substrate which are implanted with dopant. The diagram B represents the dopant concentration distribution when the dopant is implanted with an accelerating energy such that the peak point Pb is located approximately at the mid point Xb of the depth of the polysilicon layer, while the diagram C represents when the dopant is accelerated with higher energy with the result that the peak point pc is shifted to a depth Xc substantially near the interface F. Naturally, the dopant concentration at the interface F of the diagram C is much higher than that of the diagram B. In order to diffuse the dopant into the underlying silicon substrate at a favorably low temperature and form a shallow and high concentration doped region in the substrate, the dopant concentration of the doped polysilicon layer at the interface F is desirably as high as possible. Thus, the peak point of the concentration distribution of the dopant is desirable to be located as close as possible to the interface. Namely, the curve C is more preferable than the curve D. However, the depth X of the peak point P of the distribution is limited because dopant ions once penetrating the polysilicon layer and intruding into the single crystalline silicon substrate, can easily proceed further due to the channnneling effect as clearly shown in Fig. 1(b), resulting in forming an undesirably deep dopant region in the substrate. Thus, the reduced depth and the high dopant concentrations are incompatible, providing a problem which must be solved.

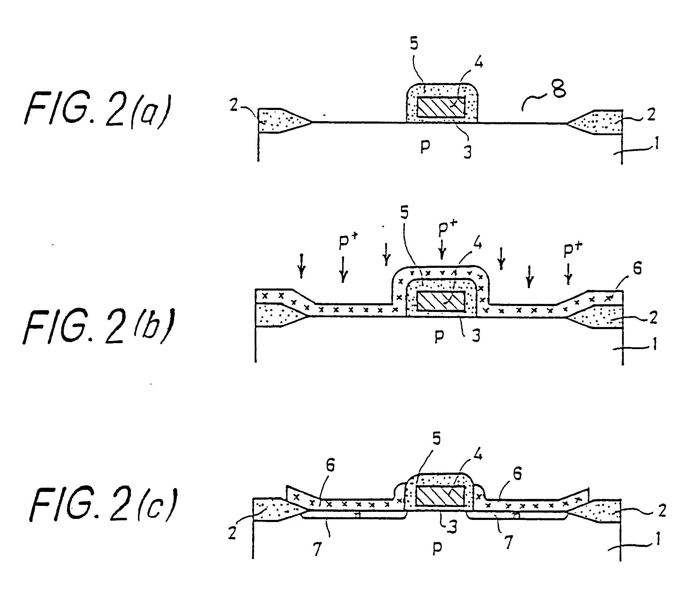

Fig. 2 (a) to (c) illustrate one example of a prior art methods for fabricating a metal-oxide field - effect transistor (MOS FET) having shallow source and drain regions (diffused regions) and contact layers connected to the source and drain regions with low contact resistance. The fabricating steps thereof are briefly described in series with reference to the drawings of Fig. 2(a) to Fig. 2(c).

Fig. 2(a); A field insulating layer 2 is selectively formed on a silicon substrate 1 of p-type, doped with boron (B) for example, employing a conventional LOCOS (Local Oxidation of Silicon) method, having a window 8, through which the surface of the silicon substrate 1 is exposed. The window 8 is selectively formed corresponding to a diffusion region. Following the formation of the layer 2, a gate electrode 4 is formed on the silicon substrate 1 through a gate insulator 3. Then, the gate electrode 4 is surrounded by an insulating layer 5. Both of the insulating layer 5 and the field insulating layer 2 are made of silicon dioxide ($SiO_2$).

Fig. 2(b); Subsequently, a polysilicon layer 6 is formed by a CVD (Chemical Vapor Deposition) method over the entire surface of the substrate 1, and phosphorus (P) ions are implanted downwardly to the surface of the substrate 1 to dope the polysilicon layer 6 in the n-type. The ions are distributed within the polysilicon layer 6. A part of the ions intrude into the upper portion of the substrate 1 passing through the polysilicon layer 6.

Fig. 2(c); Next, the polysilicon layer 6 is patterned using a photolithographic-process such that the doped polysilicon layer 6 remains selectively at least over the window 8, namely over the predetermined source-drain regions. Thereafter, the substrate 1 is subject to a heating process to activate the phosphorus (P) ions, to diffuse the phosphorus (P) ions from the doped polysilicon layer 6 to the silicon substrate 1 of p-type with the result that shallow source and drain regions 7 of n-type are formed in the substrate 1 beneath the polysilicon layer 6. The dopant concentration distribution along the depth direction of the polysilicon layer 6 and the substrate 1 is also represented in Fig. 1(b). A reduced thickness of the doped regions is difficult to be realized due to the channeling effect as described above.

## SUMMARY OF THE INVENTION

An object of the present invention is to provide a method for fabricating a semiconductor device having physical dimensions of sub-micron order.

Another object of the present invention is to provide a method for fabricating a dopant diffusion region having a reduced depth, high dopant concentration, and a high diffusion conductance.

Still another object of the present invention is to provide a method for fabricating an MOS FET having dopant diffusion region with a reduced depth, high dopant concentration, a high diffusion conductance, and a substantially low contact resistance to the associated contact terminal.

Further object of the present invention is to eliminate the defects of the prior art method that implanted dopant ions tend to proceed deep in a single crystalline semiconductor substrate hindering the realization of a shallow doped region due to the channeling effect.

To achieve the objects, a method is provided, in which an amorphized silicon layer portion is formed in a single crystalline silicon substrate by implanting ions of silicon or germanium, for example, in a portion beneath the top surface of the substrate, and a polysilicon layer of a doped metal silicide layer, is formed over the amorphized silicon layer portion. The polysilicon layer is doped by ion implantation of dopant. Hereby the dopant ions are suppressed to intrude the underlying single crystalline silicon substrate. Thus the dopant ions escape from the undesirable channeling effect. Thereafter, the substrate is subjected to a rapid thermal annealing. As the result, the dopant contained in the doped polysilicon layer or a doped metal silicide layer is thermally diffused into the amorphous silicon layer and simultaneously the amorphous silicon layer is converted to a single crystalline silicon layer by the heat treatment. Of course, at the same time, the dopants are activated, being not able to diffuse into the substrate passing through the relevant field insulator and gate insulator.

Since the dopant concentration near the interface between the polysilicon layer and the substrate is kept high, the contact resistance between both layers is substantially low. The dopant ions in the amorphized silicon layer portion are mostly activated therein, and do not go further into the underlying silicon substrate by the heat treatment so that the depth of the diffusion layer is approximately limited within the amorphized layer portion of the substrate. As the result, a shallow and highly concentration dense impurity material layer is formed.

Furthermore, since the recrystallization of the amorphized silicon layer is easy and the activation ratio of the dopant ions in the amorphized silicon layer is favorably high, the temperature of the associated heat treatment can be selected favorably low, which leads to various fabricating advantages.

The features and advantages of the present invention will be apparent by reading of the following description and the claims with reference to the following drawings in which like reference numerals represent like parts.

## BRIEF DESCRIPTION OF THE DRAWINGS

Fig. 1 are schematic diagrams, illustrating the distribution of the dopant concentration taken in the direction normal to the semiconductor substrate.

Fig. 2 are cross-sectional views illustrating a series of prior art fabricating steps arranged in order.

Fig. 3 are cross-sectional views, illustrating a series of fabricating steps of a first embodiment according to the present invention arranged in order, and

Fig. 4 are cross-sectional views illustrating a series of fabricating steps of a second embodiment according to the present invention arranged in order.

## DESCRIPTION OF EMBODIMENTS

The detail to the present invention is described in the following with reference to drawings.

Figs. from 3 (a) to 3(d) are cross-sectional views illustrating the fabricating steps of a first embodiment according to the present invention, presented in series.

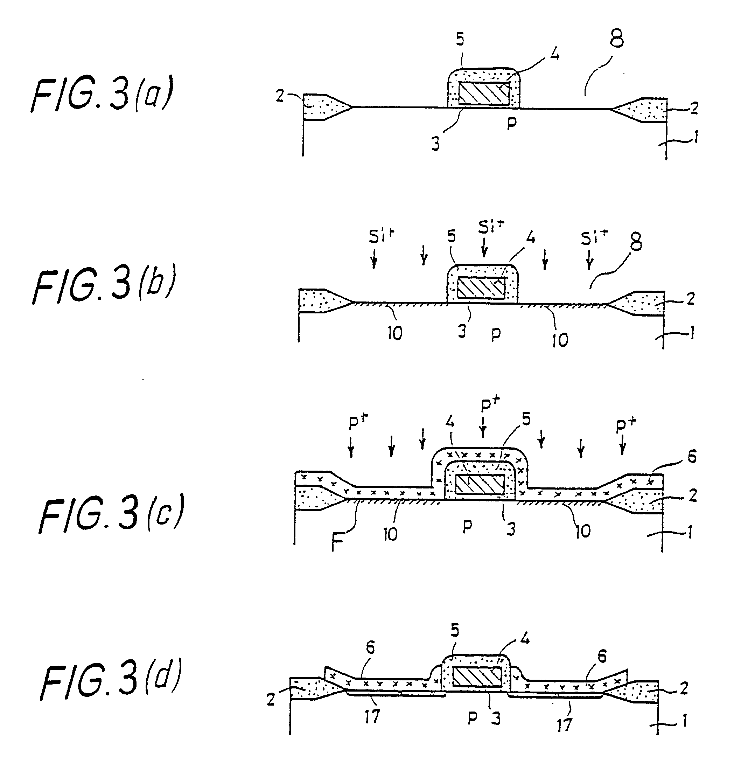

Refer to Fig. 3(a); A single crystalline silicon substrate 1 of p-type, doped with boron (B) of the concentration of $10^{15}$ cm3 is prepared. On the silicon substrate 1, a field insulating layer 2 having a window 8 is formed over the surface of the substrate using a conventional method. Then, a gate electrode 4 is formed on the surface of the substrate 1 exposed through the window through a gate insulator 3, being surrounded by an insulating film 5 made of silicon dioxide ($SiO_2$). The forming methods employed are the known ones.

Refer to Fig. 3(b); Next, a layer portion beneath the exposed surface of the substrate 1 is amorphized by downwardly implanting silicon (Si) ions to the surface of the substrate 1. The ions are implanted through the window 8 except for the portion covered by the insulating film 5 under a condition, for example, of an accelerating energy of 40 KeV, and the dose of $4\times10^{15}$ cm². An amorphous silicon layer 10 is thus formed beneath the surface of the substrate 1, having a thickness of approximately 300 to 1000 Angstrom.

Refer to Figs. 3(c); Next, a polysilicon layer 6 with a thickness of approximately 2000 Angstrom, is formed covering the entire surface of the substrate 1, employing a conventional CVD method, following which phosphorous (P) ions are implanted into the polysilicon layer 6 which is doped in the n-type with a dopant concentration of $10^{20}$ cm3. The implanting condition is of an accelerating energy of 70 KeV and the dose of $4\times10^{15}$ cm².

Refer to Fig. 3(d); Thereafter, the polysilicon layer 6 is patterned by a conventional photolithographic process such that the doped polysilicon layer 6 is selectively left over the predetermined source and drain regions, namely over the windows 8.

Subsequently, the substrate 1 is subject to a conventional rapid thermal annealing (RTA) method and heated an 1000 centigrade for 10 seconds. Thereby, the implanted phosphorus (P) ions are activated, being diffused from the polysilicon layer 6 into the underlying amorphous silicon layer 10 which is simultaneously recrystallized and converted to a single crystalline silicon layer. Consequently, n-type source and drain regions 17 are formed. Thus formed source and drain regions 17 are shallow diffusion layers with high dopant concentration. The depth of the regions is approximately 600 Angstrom, and the dopant concentration near the interface is approximately $10^{20}$ cm3.

In the above described fist embodiment, the doped polysilicon layer is formed by ion implanting of the relevant dopant to the polysilicon layer 6. The dopant concentration distribution is represented by the diagram D shown in Fig. 1(c). The accelerating energy of the dopant ion implantation is selected considering the thickness of the polysilicon layer 6 such that the peak point Pd is located substantially near the interface F. Naturally a portion of the implanted dopant ions go into the amorphized layer 10, being suppressed to proceed further because of the amorphized structure of the layer 10. The intrusion of the ions into the underlying single crystalline silicon substrate 1 is thus prevented, and the ions are escaped from the channeling effect. As shown in Fig. 1(c), the dopant concentration diagram D is rapidly falling down in the amorphized layer 10. As the result, the diffusion region 17 formed by the subsequent RTA has a reduced depth almost limited within the amorphized layer 10, and the dopant concentration thereof is favorably high since the dopants in the region 17 are supplied from the doped polysilicon layer 6 by thermal diffusion and the dopant ions contained in the polysilicon layer, being added the dopant ions contained in the amorphized layer portion 10.

In addition, the contact resistance between the polysilicon layer 6 and the diffusion layer 17 is substan tially low, since the dopant concentration near the interface between both layers is high.

Furthermore, since the recrystallization of the amorphized silicon layer 10 is easy and the activation ratio of the dopant ions in the amorphized silicon layer 10 is high, the temperature of the associated heat treatment can be favorably low, leading to various fabricating advantages.

The doped polycristalline layer 6 functions as a contact terminal to each diffusion region 17 since the layer 6 has a favorable electrical conductivity. The electrical conductivity can be enhanced by converting the polysilicon layer 6 to a silicide layer, the method of which is disclosed next.

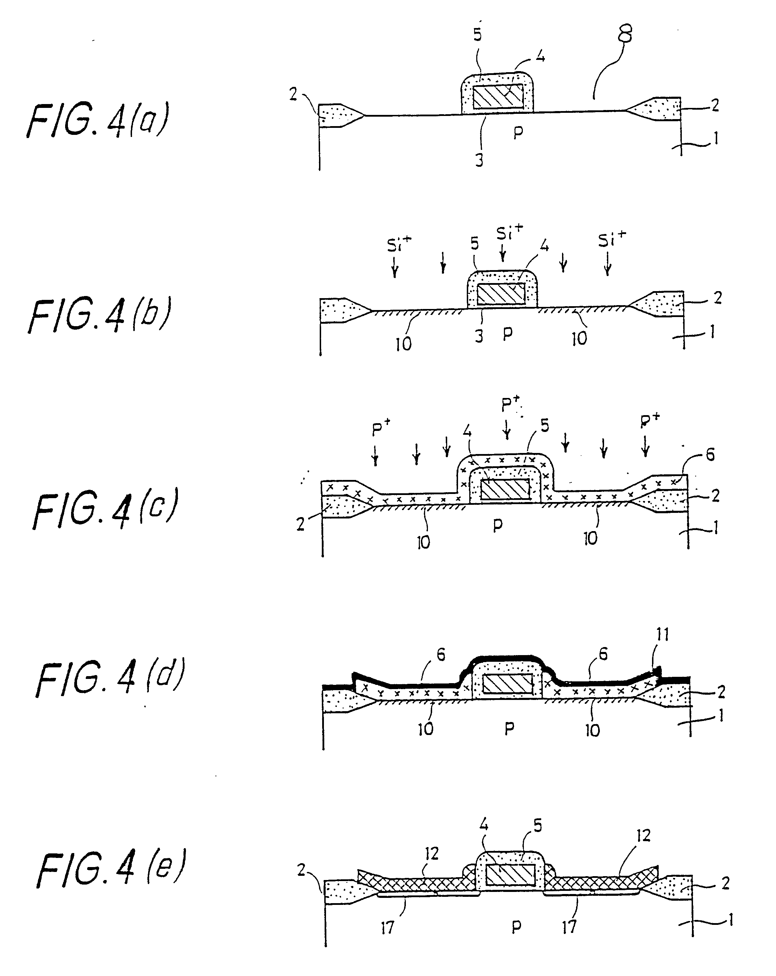

A second embodiment is described with reference to cross-sectional views of Figs. 4(a) to (e), illustrating the series of the fabricating steps.

Refer to Fig. 4(a): In the similar manner of the first embodiment, a field insulating layer 2 having a window 8 is selectively formed over the surface of a silicon substrate 1 of p-type, doped with boron (B) of the concentration of $10^{15}$ cm$^3$, employing a conventional method. Then, a gate electrode 4 is formed through a gate insulator 3 on the surface of the substrate exposed through the window 8, being surrounded by an insulating film 6.

Refer to Fig. 4(b): Next, an amorphized silicon layer portion 10 having a depth of approximately 300 to 1000 Angstrom, is formed over an exposed surface of the substrate 1 by downwardly implanting silicon (Si) ions thereinto. The ions are implanted under the conditions, for example, of a accelerating energy of 40 KeV, and the dose of $4 \times 10^{15}$ cm$^2$.

Refer to Fig. 4(c): Next, a polysilicon layer 6 having a thickness of approximately 2000 Angstrom, is formed over the entire surface of the substrate 1 by a conventional CVD method, following which phosphorous (p) ions are implanted to dope the polysilicon layer 6 in the n-type to have a dopant concentration of $10^{20}$ cm$^3$. The implanting condition is of an accelerating energy of 70 KeV, and the dose of $4 \times 10^{15}$/cm$^2$.

Refer to Fig. 4(d): Thereafter, the polysilicon layer 6 is patterned by a conventional photolithographic process such that the doped polysilicon layer 6 is selectively remained over at least the predetermined source-drain regions, namely diffusion regions. Subsequently, a titanium (Ti) film 11 is formed thereon employing a conventional sputtering method.

Refer to Fig. 4(e): Thereafter, upon being subject to a rapid heat treatment (RTA) using a halogen lamp with a temperature rise of approximately 650 centigrade for 1 minute, the polysilicon layer 6 and the titanium (Ti) film 11 formed thereon, chemically react with each other, forming a titanium silicide layer 12. While the titanium (Ti) film 11 formed over the field insulating oxide layer 2 does not react with each other. The remaining titanium (Ti) film 11 is selectively removed with a usual chemical etching process using acids. After the removal, the substrate is heated at 750 centigrade for 30 seconds. The doped phosphorus (P) ions are diffused from the polysilicon layer 6 into the underlying amorphous silicon layer portion 10, which is simultaneously recrystallized and converted to a single crystalline silicon layer, and the phosphorus (P) ions are activated at the same time. As the result, there are formed n-type source and drain regions 17 having a reduced depth, such as approximately 600 Angstrom, and high dopant concentration of approximately $10^{20}$/cm$^3$ almost in the recrystallized layer portion 10.

In the above described second embodiment, the formation of the titanium silicide film 12 and that of the diffused regions (source and drain regions 17) are performed simultaneously. While, in another method, a silicide layer is formed first employing a CVD method, and then the phosphorus (P) ions are implanted into the silicide layer to dope the silicide layer. Thereafter, the phosphorous (p) ions are diffused into the amorphous silicon layer 10. Furthermore, other than the titanium silicide layer, a platinum silicide layer, a cobalt silicide layer, a tungsten silicide layer, a molybdenum silicide layer, a hafnium silicide layer, a vanadium silicide layer, and a zirconium silicide layer are applicable as a metal silicide layer. As a dopant material except for phosphorus (P), arsenic (As) is applicable, and as a p-type dopant, boron (B) and boron fluoride (BF$_2$) are applicable.

In both of the first and second embodiments, the amorphous silicon layer portion is formed by ion planting the surface of the substrate 1. While, an amorphous silicon layer can be formed using a CVD method over the surface of the substrate before or after the formation of the field insulating layer 2. Furthermore, the polysilicon layer 6 may be doped to some degree in advance before the subsequent dopant ion implantation shown in Fig. 3(c) or Fig. 4(c). The preliminary doping of the polysilicon layer 6 is advantageous to reduce doping amount of the following ion implantation.

With the above-described fabricating method according to the present invention, the structure of an MOS transistor can be miniaturized and a short channel effect of the transistor is reduced, resulting in substantially improving the function and reliability of the transistor.

The present invention is further applicable to the improvement of a bipolar transistor by miniaturizing the emitter contact thereof. Furthermore, in the above description, a doped silicon substrate or silicon layers are mentioned. However, it is apparent for the skilled person in the art, that the present invention is applicable to the fabrication of another semiconductor device such as a gallium-arsenic (GaAs) transistor.

As is apparent from the above description, with respect to the fabrication of a semiconductor device, such as an MOS FET, the contact resistance and the diffusion resistance of the relevant dopant regions can be reduced and the physical dimensions, particularly the depth of the dopant region is favorably reduced. As the result, the present invention can effectively contribute to the miniaturization and the improvement of the function of the associated transistor.

## Claims

1. A method for forming diffusion regions in a semiconductor substrate, said method comprising the steps of:

(a) forming an amorphous semiconductor layer portion on a surface of said semiconductor substrate;

(b) forming a semiconductor layer containing dopant material therein over said amorphous semiconductor layer portion;

(c) patterning said semiconductor layer by selectively remaining said semiconductor layer over the predetermined diffusion regions to be formed in said semiconductor substrate; and

(d) heating said semiconductor substrate for thermally diffusing said dopant material contained in said patterned semiconductor layer into said amorphous silicon layer, and simultaneously recrystallizing said amorphous semiconductor layer and activating said dopant material in said recrystallized semiconductor layer, thus forming said diffusion regions in said semiconductor substrate.

2. A method for fabricating diffusion regions in a semiconductor substrate of claim 1, wherein the semiconductor is silicon and said diffusion regions are a source region and a drain region of a metal-insulator-silicon (MIS) field effect transistor (FET).

3. A method for fabricating diffusion regions in a semiconductor substrate of claim 2, wherein said amorphous silicon layer in the step (a) is formed by implanting silicon ions into said silicon substrate.

4. A method for fabricating diffusion regions in a semiconductor substrate of claim 2, wherein the step (c) of forming a silicon layer containing dopant material therein comprises the sub-steps of:
forming a silicon layer over said amorphous silicon layer; and
implanting dopant material into said silicon layer.

5. A method for fabricating diffusion regions in a semiconductor substrate, comprising the steps of:

(a) forming an amorphous silicon layer on a surface of said silicon substrate;

(b) forming a silicon layer containing dopant material doped therein over said amorphous silicon layer;

(c) patterning said doped silicon layer to be remained on said amorphous silicon layer;

(d) coating said doped silicon layer with a metal film over said doped silicon layer;

(e) heating said patterned polycrystalline silicon layer,
resulting in chemically reacting said polycrystalline silicon layer and said metal film to form a metal silicide layer with respect to said metal on said polycrystalline layer, ·
thermally diffusing said dopant material contained in said patterned polycrystalline layer into said amorphous silicon layer, and
simultaneously recrystallizing said amorphous silicon layer, and activating said dopant material in said recrystallized silicon layer, thus forming said diffusion regions.

6. A method for fabricating diffusion regions in a semiconductor substrate of claim 5, wherein said metal is a metal selected from a group of titanium (Ti), tungsten (W), molybdenum (Mo), platinum (Pt), cobalt (Co), hafnium (Hf), vanadium (Va) and zirconium (Zr).

single crystalline silicon substrate

dopant concentration

$P_a$

$X_a$

A

depth

*FIG. 1 (a)*

polysilicon layer

single crystalline silicon substrate

dopant concentration

$P_b$

$P_c$

$X_b$

$X_c$

C

B

F

depth

*FIG. 1 (b)*

amorphized layer portion

polysilicon layer

single crystalline silicon substrate

dopant concentration

$P_d$

$X_d$

D

F

depth

*FIG. 1 (c)*

EP 0 361 078 A2

FIG. 2(a)

FIG. 2(b)

FIG. 2(c)

FIG. 3(a)

FIG. 3(b)

Si⁺            Si⁺            Si⁺

FIG. 3(c)

p⁺            p⁺            p⁺

FIG. 3(d)

FIG. 4(a)

FIG. 4(b)

FIG. 4(c)

FIG. 4(d)

FIG. 4(e)